(19) **Europäisches Patentamt**
**European Patent Office**
**Office européen des brevets**

(11) Publication number: **0 032 437**
**A1**

(12) # EUROPEAN PATENT APPLICATION

(21) Application number: **81300087.4**

(22) Date of filing: **09.01.81**

(51) Int. Cl.³: **H 01 L 21/603**

(30) Priority: **16.01.80 US 112660**

(43) Date of publication of application:
**22.07.81 Bulletin 81/29**

(84) Designated Contracting States:
**BE CH DE FR GB LI NL**

(71) Applicant: **AMERICAN COLDSET CORPORATION**
**15879 Midway Road**
**Addison Texas 75001(US)**

(72) Inventor: **Thompson, Charles Mark**
**524 Christi Lane**
**Coppell Texas 75019(US)**

(72) Inventor: **Thompson, Charles Trivett**
**5624 Brookstown**
**Dallas Texas 75230(US)**

(72) Inventor: **Payne, David H.**
**712 Timberlake**
**Richardson Texas 75080(US)**

(74) Representative: **Marsh, Roy David**
**Brewer & Son 5-9, Quality Court Chancery Lane**
**London WC2A 1HT(GB)**

(54) Thermocompression bonding tool.

(57) There is disclosed a thermocompression bonding tool (10) adapted for the bonding of electrodes of an integrated circuit to the lead wires of a circuit board. The tip (11) of the bonding tool which applies compression and heat to the electrodes and lead wires during the bonding operation is formed from a mass of synthetic polycrystalline diamond material sintered in a predetermined form. The tip (11) is mounted upon a holder (12) which is electrically heated, thereby heating the tip. Due to the high conductivity of the diamond tip, heat can readily be transferred during the bonding operation. The hardness of the diamond tip gives it an extremely long life.

Fig. 1.

EP 0 032 437 A1

1

## THERMOCOMPRESSION BONDING TOOL

The invention relates to a bonding tool used for the assembly of semiconductor devices such as integrated circuits or chips to lead wires of a circuit board or the like. During assembly, electrodes on the chip are bonded by a soldering operation to the lead wires. The electrodes and the lead wires are coated with material such as tin or other suitable solder at least over the areas where they are to be bonded. By the application of heat and pressure by the bonding tool, soldered connections are obtained.

It is desired to perform the bonding operation in a brief amount of time in order to prevent undue heating of the chip and the circuit board to which the chip is to be bonded. This requires a rapid transfer of heat during the bonding operation. In addition, a reduction in the time of carrying out a bonding operation enables the rate of production of bonding to be increased. Since the tip of the bonding tool must be operated at an elevated temperature and be subjected to compressive forces and friction during bonding, it is desired to form the tip from a material that not only can readily transfer heat but also can resist

2

wear. In this way, the tip can be used for an appreciable number of cycles of operation, such as for example, hundreds of thousands of cycles of operations.

The shape and size of a tip for a bonding tool can vary as determined by the configuration of electrodes and lead wires which are to be bonded. A tip can be adapted to bond simultaneously a plurality of electrodes of a chip extending along each of the sides of the chip. In the alternative, the tip may be simply a compact point for bonding a very limited area. Accordingly, if diamond material is to be used for the tip, an appreciable range of sizes and shapes must be accommodated.

It is known prior to the invention to utilize natural diamond material for the tip of a soldering tool in view of the superior thermal conductivity of diamond material and the wear resistance therof. The use of soldering tools with natural diamond material has been limited to comparatively small tips of simple forms due to the cost of natural diamond material and due to the difficulty in forming diamond material as a result of its extraordinary hardness. Where it is required that a bonding tool tip have comparatively large dimensions or an irregular shape such as one having a recess on its face, there is presented a formidable task in attempting to shape such a tip from natural diamond material. Thus, conventional but highly developed grinding processes for forming flat surfaces on natural diamond material may be unsuitable for forming tips for bonding tools.

U.S. Patent No. 3,555,950, which issued on January 19, 1971, discloses a cutting tool having an electrically heated tip of apparently natural diamond material. The tip is in the form of a sharp chisel for cutting metal foils disposed upon a substrate in the manufacture of photomasks. The cutting tool is not used in a thermocompression bonding process.

U.S. Patent No. 3,393,855 which issued on July 23, 1968, discloses a bonding tool for thermocompression bonding in which an electrically heated tip is formed from sapphire material.

It is a primary object of the invention to provide a tip for a thermocompression bonding tool capable of high heat transfer and having extremely high resistance to wear.

It is a further object of the invention to provide a tip for a thermocompression bonding tool which is formed from extraordinarily hard material and yet can be produced in a range of sizes and shapes including shapes having recess therein.

It is also an object of the invention to provide a tip for a thermocompression bonding tool which can resist cracking under load.

It is an additional object of the invention to provide a tip for a thermocompression bonding tool which resists being wetted by liquid or fused material and thereby resists contamination during use.

In accordance with the invention, there is provided a tip for a thermocompression bonding tool with the tip being formed of synthetic polycrystalline masses of hard materials such as synthetic polycrystalline masses of diamond material.

A tip formed of polycrystalline diamond masses in accordance with the invention has the advantages of the properties of natural diamond material such as high thermal conductivity and extreme hardness, properties which enable the tip to transfer heat rapidly with little temperature drop and to have great resistance to wear.

A tip formed of syntehtic polycrystalline diamond masses in accordance with the invention has the advantage of being readily produced in a variety of sizes and shapes as a result of the compacting and sintering processes used in manufacturing such diamond masses.

A tip formed in accordance with the invention has the advantage of eliminating the need of carrying out the slow, complex and difficult cutting and grinding processes which must be used in forming a tip from natural diamond material.

5

A tip formed in accordance with the invention also has the advantage of having the property of high resistance to cracking as a result of the synthetic polycrystalline diamond mass, a property not found in tips made from natural diamond material.

FIG. 1 is an elevational view of a thermocompression bonding tool having the tip of the invention;

FIG. 2 is an enlarged fragmentary end view of the tip of the invention;

FIG. 3 is an enlarged vertical section view of the tip of the invention in contact with a workpiece;

FIG. 4 is an enlarged perspective view of an integrated circuit or chip which can be bonded by the tip of the invention;

FIG. 5 is an enlarged fragmentary perspective view showing a recessed tip in accordance with the invention and a circuit board upon which a chip has been bonded; and

FIG. 6 is an enlarged fragmentary vertical section view of the recessed tip of the invention in contact with a workpiece.

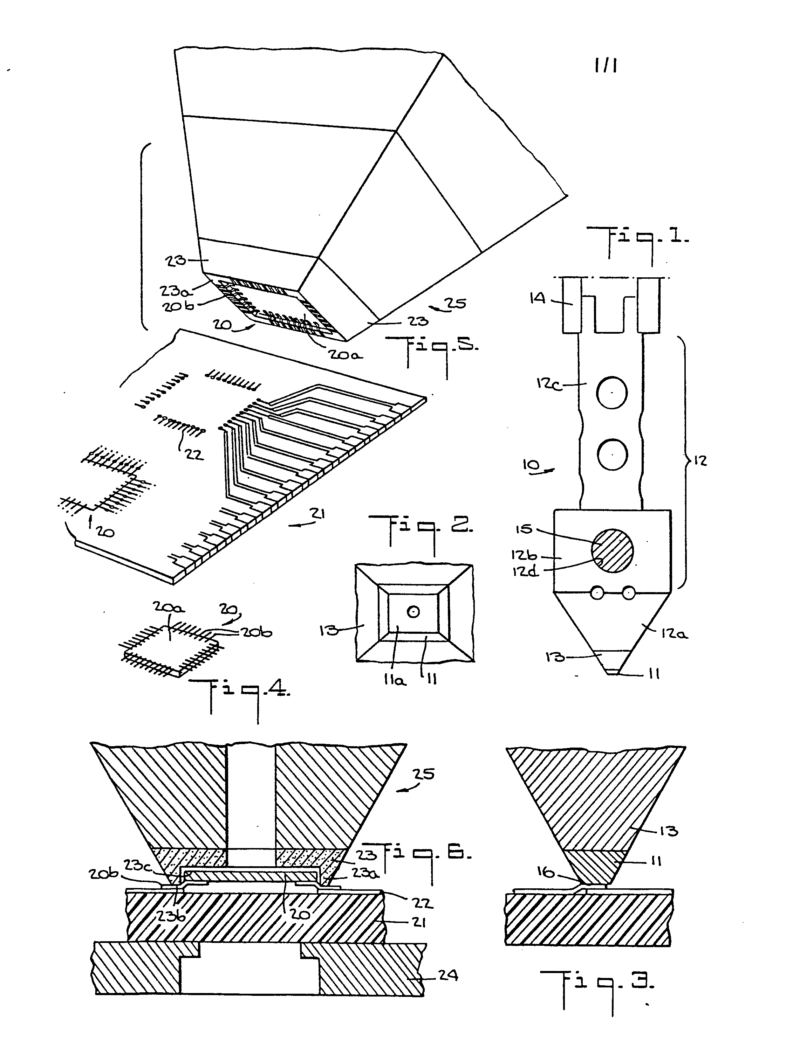

As shown in FIG. 1, bonding tool 10 in accordance with the invention comprises tip 11 mounted upon holder 12. Holder 12 includes head portion 12a and base portion 12b. Tip 11 is mounted upon surface 12a of head portion 12a. Holder 12 further includes shank 12c which is adapted to be inserted into a support 14. The holder can be heated and thereby the tip by an electrical heating element 15 disposed about shank 12c.

Tip 11 comprises polycrystalline hard material such as synthetic sintered polycrystalline diamond masses. Sintered polycrystalline diamond masses are marketed as manmade diamond compacts by the General Electric Company under the trademark STRATAPAX. Synthetic sintered polycrystalline diamond masses are the result of direct diamond-to-diamond bonding without dependence upon the presence of any intermediate bonding material between the diamond grains. As a result of the extensive diamond-to-diamond bonds within the mass, there is excellent crack resistance. To the contrary in a single-crystal natural diamond, a crack once formed can propagate throughout the single crystal.

The synthetic sintered polycrystalline diamond masses are available in various forms including disks, sectors of disks, and cores. By way of example, disks or sectors of disks may comprise a thin (0.5 to 1.5 mm) layer of sintered diamond up to about 13mm diameter. The layer of sintered polycrystalline diamond material diamond may be bonded to a cemented tungsten carbide-base block, for example, a block of about 3mm thick. Core blocks, by way of example, may have synthetic sintered polycrystalline diamond cores up to 6mm in diameter and 6mm in length.

7

Synthetic diamond and sintered synthetic diamond masses are described in the Encyclopedia of Chemical Technology, Kirk-Othmer, Third Edition, Volume 4, John Wiley & Sons, 1978, pages 676-688.

In order to utilize a synthetic polycrystalline diamond mass as a tool or in the case of a bonding tool, as a tip, it is of advantage to be able to form a bond between the mass and the holder. In connection with synthetic sintered diamond compacts bearing the trademark STRATAPAX, the General Electric Company has developed a process for bonding the synthetic sintered diamond compact to a metal surface such as that of a holder. This method is described in the publication entitled "The Oil And Gas Journal", February 19, 1979, Edition pages 111-114. In brief, the process developed by the General Electric Company involves metallization of the surface of the sintered diamond mass, the placement of a metal body such as that of cemented tungsten carbide material against the metallized surface, and the subjecting of the body and the sintered diamond mass to high temperature and high pressure at the interface thereof. As a result, a diffusion bonding occurs between the cemented tungsten carbide base and the sintered diamond mass. Thereafter, the base with the sintered diamond mass bonded thereto may be permanently mounted upon a holder by brazing, welding or the like.

8

As shown in FIGS. 1 and 2, tip 11 in accordance with an embodiment of the invention comprises a disk of synthetic polycrystalline diamond material bonded to substrate 13. By way of example, the substrate can be formed of metal material such as cemented tungsten carbide. Tip 11 can comprise a synthetic sintered diamond compact of the type sold by the General Electric Company under the trademark STRATAPAX. The compact can be bonded to substrate 13 by the diffusion bonding method referred to in the publication entitled "The Oil And Gas Journal" as discussed above. In turn, substrate 13 can be mounted upon head portion 12a of holder 12 by brazing or welding.

Electrical heating element 15 can be disposed in opening 12d within shank 12c of hold 12 to deliver heat to the holder (FIG. 1). The heat can then readily flow through base portion 12b, head portion 12a, and substrate 13 to tip 11 and thereby to a workpiece to be subjected to heat and pressure.

As shown in FIG. 2, tip 11 can be in the form of a truncated pyramid. Such a form results in an end face 11a which can contact a workpiece 16 (FIG. 3). Even though the tip is comparatively small as compared to substrate 13 and head portion 12a, there can be a high degree of heat transfer through the tip due to its high thermal conductivity. Here it is noted that diamond material of the kind designated Type 1a or Type 1b (the class of diamond material having some degree of impurities therein) has a thermal conductivity of about 9W/(cm-K) at 20°C. At 190°C, Type 1 diamond material has a thermal conductivity of approximately 4W/(cm-K). Thus, it can be seen that synthetic diamond tip 11 in accordance with the invention can have a thermal conductivity similar to that of copper [4W(cm-K) at 20°C] while at the same time having the extreme hardness of diamond material where copper, to the contrary, is a soft material.

Another advantage of utilizing sintered polycrystalline diamond material is that it is highly resistant to being wetted by a liquid or a material in a molten state. This characteristic necessitates the use of a bonding process such as the diffusion bonding process discussed above if diamond material is to be bonded to a metal material of substrate. In the case of a thermocompression bonding tool, the polycrystalline diamond tip 11 of the invention is not wetted or contaminated by the workpiece or soldering material during a bonding operation. As a result, the tip remains totally free of contaminants after extensive use and accordingly can produce a great number of bonds without the need of servicing or replacement.

In FIG. 4, there is shown integrated circuit or chip 20 having a body portion 20a with a plurality of circuit elements (not shown) such as semiconductor circuit elements formed therein. From body portion 20a extends electrodes 20b which are connected to the circuit elements of body portion 20a. It is evident that in order to insert chip 20 into one or more electrical circuits, it is necessary to form connections at the various electrodes 20b. If an attempt was made to individually connect the electrodes to circuits such as the lead wires extending therefrom, a tedious and time-consuming operation would be required. Such an operation could likely damage the chip itself. Accordingly, it is desired to form connections between electrodes of the chip and other circuits in the simplest and quickest manner.

FIG. 5 shows a circuit board 21 having lead wires 22 which are to be connected to electrodes 20b of chip 20. In order to bond electrodes 20b to lead wires 22, there can be provided recessed tip 23 which is another embodiment of the invention. Recessed tip 23 is formed of synthetic polycrystalline diamond material in accordance with the invention (FIG. 6). Thus, recessed tip 23 comprises peripheral portion 23a surrounding an open recess 23c. The working surface of tip 23 is peripheral face portion 23b which is rectangular in form and surrounding the recess within tip 23. Face portion 23b is adapted to compress electrodes 20b against lead wires 22 in order to bond the electrodes to the lead wires as shown in FIG. 5. Thus, if the electrodes and lead wires are as shown in FIG. 5. Thus, if the electrodes and lead wires are coated with tin or solder, upon the application of heat and pressure by recessed tip 23, the electrodes will be bonded to the lead wires.

The recessed tip 23c within tip 23 prevents the tip from contacting the body portion 20a of chip 20. Thus, as shown in FIG. 6, recessed tip 23c provides a clearance about chip 20 during a bonding operation. Further as shown in FIG. 6, an anvil or supporting member 24 may be employed beneath circuit board 21 to support the circuit board in the region beneath lead wires 22 during the bonding operation.

It should be noted that only by using a synthetic polycrystalline diamond mass in accordance with the invention can a shape such as that of recessed tip 23 be practically achieved. Thus, it would be prohibitively expensive and wasteful to attempt to form a recess in a piece of natural diamond material by cutting, grinding, sawing, or lasing procedures due to the extraordinary hardness of natural diamond material. Furthermore, if natural diamond material was to be recessed, it would

12

still lack the advantage of a synthetic polycrystalline diamond mass whereby the synthetic polycrystalline diamond mass can resist cracking when subject to excessive force.

FIG. 6 shows that holder 25 and recessed tip 23 may be provided with passages 25a and 23d, respectively.

Tip 11 and recessed tip 23 are simply representative embodiments of the invention. Thus, they are not exhaustive of configurations for a tip which can be formed of synthetic polycrystalline diamond material in accordance with the invention. Thus, tips of a multiplicity of different forms can be provided in accordance with the invention. In addition, where it is desired to provide a tip having sufficiently large dimensions such as versions of recessed tip 23, the tip can be formed from an assembly of elements, each of which is a synthetic polycrystalline diamond mass. Accordingly, not only a recessed structure but tips having a variety of shpes and sizes can be fabricated in accordance with the invention from a plurality of discrete bodies, each formed of synthetic polycrystalline diamond material.

The disclosure of the tip of the invention has included synthetic polycrystalline diamond masses as the preferred material since this material has the greatest hardness, superior thermal conductivity, and extreme resistance to wetting. Here it is noted that the high

13

degree of thermal conductivity enables sufficient heat to be transferred by the tip at a temperature lower than would be the case where the tip had higher less thermal conductivity.

Other synthetic polycrystalline hard materials can be used for the tip of the invention provided that they can be sintered and have sufficient hardness and thermal conductivity. Other hard synthetic hard materials include corundum (ruby or sapphire), spinel, titania, emerald, etc.

0032437

- 14 -

CLAIMS:

1. A tip for a tool for transferring heat to a workpiece when in contact therewith characterised in that it comprises a body (11) of synthetic polycrystalline hard material having substantially high thermal conductivity, and including a surface portion (11a) for contacting a workpiece to transfer heat thereto and another surface portion for receiving heat from the tool (10).

2. A tip for a tool in accordance with claim 1, characterised in that the tip (11) is formed of synthetic polycrystalline diamond material.

3. A tip for a tool in accordance with claim 2, characterised in that the synthetic polycrystalline diamond material is sintered.

4. A tip for a tool in accordance with any one of the preceding claims, characterised in that it further comprises a substrate (13) of metallic material bonded to the other surface portion of the tip for engagement with the tool (10) to receive heat therefrom.

5. A tip for a tool in accordance with claim 4, characterised in that the substrate (13) comprises a cerment material.

6. A tip for a tool in accordance with claim 5, characterised in that the substrate (13) comprises tungsten carbide material.

7.        A tip for a tool in accordance with any one of the preceding claims, characterised in that the body (11) of synthetic polycrystalline hard material comprises a compact which is manufactured in a predetermined form.

8.        A tip for a tool in accordance with claim 7, characterised in that the compact is provided with a recess (23c) in the surface portion thereof, the surface portion (23a) adjacent the recess being adapted to contact a workpiece.

9.        A tip for a tool in accordance with any one of the preceding claims, characterised in that the tip (11,23) is formed of a plurality of separate pieces.

10.       A tip for a tool in accordance with any one of the preceding claims, characterised in that the area of the surface portion (11a) is less than the area of the other surface portion.

11.       A tip for a tool in accordance with any one of the preceding claims, characterised in that the tip (11,23) is in the form of a prism.

12.       A tool for transferring heat to a workpiece characterised in that it comprises a holder (12) having a base portion (12a) thereon, the holder being adapted to transfer heat to the base portion, and a tip (11) mounted on the base portion, and adapted to transfer heat from the holder to a workpiece, when in engagement therewith, the tip comprising synthetic polycrystalline hard material.

- 16 -

13.      A tool in accordance with claim 12, characterised in that the tip (11) is formed of synthetic polycrystalline diamond material.

14.      A tool in accordance with claim 13, characterised in that the synthetic polycrystalline diamond material is sintered.

15.      A tool in accordance with any one of claims 12 to 14, characterised in that the portion of the tip mounted on the holder comprises a layer (13) of cerment material bonded to the synthetic crystalline hard material.

16.      A tool in accordance with claim 15, characterised in that the cerment material comprises tungsten carbide material.

17.      A tool in accordance with any one of claims 12 to 16, characterised in that the holder is provided with a cavity (12d) therein and that it further comprises a heating element (15) disposed in the cavity.

0032437

1/1

Fig.1.

Fig.2.

Fig.3.

Fig.4.

Fig.5.

Fig.6.

0032437

European Patent
Office

**EUROPEAN SEARCH REPORT**

Application number

EP 81300087.4

| DOCUMENTS CONSIDERED TO BE RELEVANT | | | CLASSIFICATION OF THE APPLICATION (Int Cl.³) |
|---|---|---|---|
| Category | Citation of document with indication, where appropriate, of relevant passages | Relevant to claim | |
| D,A | <u>US - A - 3 393 855</u> (MOSER)<br>+ Fig. 1-7 +<br>-- | | H 01 L 21/603 |
| | <u>DE - B1 - 2 818 911</u> (GERBER)<br>+ Fig. 1-10; column 2, lines 7-17 +<br>-- | 1-4,<br>11-14 | |
| A | <u>DE - A - 2 260 722</u> (CASTELLANA)<br>+ Fig. 1-3 +<br>-- | | **TECHNICAL FIELDS SEARCHED (Int. Cl.³)** |
| | <u>GB - A - 913 610</u> (SIEMENS)<br>+ Fig. 1-6; claims 1-5 +<br>---- | 9 | B 23 K 1/00<br>B 23 K 3/00 |

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

| X | The present search report has been drawn up for all claims | | |
|---|---|---|---|
| Place of search<br>VIENNA | Date of completion of the search<br>03-04-1981 | Examiner<br>BERGER | |

EPO Form 1503.1  06.78